Europäisches Patentamt

**European Patent Office**

Office européen des brevets

(11) Publication number : **0 354 547 B1**

(12) # EUROPEAN PATENT SPECIFICATION

(45) Date of publication of patent specification :
12.10.94 Bulletin 94/41

(51) Int. Cl.⁵ : **G05F 3/02, H03K 17/92**

(21) Application number : **89114718.3**

(22) Date of filing : **09.08.89**

(54) **Regulator of power source for superconducting circuit.**

(30) Priority : **10.08.88 JP 199116/88**

(43) Date of publication of application :
**14.02.90 Bulletin 90/07**

(45) Publication of the grant of the patent :
**12.10.94 Bulletin 94/41**

(84) Designated Contracting States :
**DE GB**

(56) References cited :
PATENT ABSTRACTS OF JAPAN vol. 8, no.
103 (E-244)(1540) 15 May 1984, & JP-A-59
19437 (HITACHI SEISAKUSHO K.K) 31 January
1984,
PATENT ABSTRACTS OF JAPAN vol. 7, no.
239 (E-206)(1384) 25 October 1983, & JP-A-58
129826 (NIPPON DENSHIN DENWA KOSHA) 3
August 1983,
PATENT ABSTRACTS OF JAPAN vol. 7, no.
208 (E-198)(1353) 14 August 1983, & JP-A-58
103225 (NIPPON DENSHIN DENWA KOSHA)
20 June 1983

(56) References cited :
IBM TECHNICAL DISCLOSURE BULLETIN vol.
25, no. 3B, August 1982, pages 1713 -1714; W.
H. CHANG: "JOSEPHSON DEVICE REGU-
LATOR CIRCUIT"
IBM TECHNICAL DISCLOSURE BULLETIN vol.
24, no. 2, July 1981, pages 1101 - 1104;D. J.
HERRELL: "DWELL-TIME TECHNIQUE FOR
AC POWER OF JOSEPHSON CIRCUITS"

(73) Proprietor : **FUJITSU LIMITED**
**1015, Kamikodanaka**
**Nakahara-ku**
**Kawasaki-shi Kanagawa 211 (JP)**

(72) Inventor : **Suzuki, Hideo c/o Fujitsu Limited**
**Patent Department**
**1015 Kamikodanaka**
**Nakahara-ku Kawasaki-shi Kanagawa 211**
**(JP)**

(74) Representative : **Sunderland, James Harry et**
**al**
**HASELTINE LAKE & CO**
**Hazlitt House**
**28 Southampton Buildings**
**Chancery Lane**
**London WC2A 1AT (GB)**

## Description

The present invention relates to a regulator of a power source for a superconducting circuit.

Typically, a logic circuit employing Josephson junctions is driven by a current and normally operates in a latching mode. It should be noted that this latching mode is a mode wherein, once a logic circuit constituted by Josephson junctions is switched by an input control signal (from the superconducting state to the normal conducting state), the logic circuit continues to hold its switched state, even if thereafter the input control signal is removed. In order to release such a latching mode, it is necessary to bring the bias current supplied to the logic circuit momentarily to zero. For this reason, in superconducting circuits that employ the latching mode, a clock power system is employed wherein, after a logic operation has been effected in one logic interval, each logic gate is returned to a "0" state by making bias current zero, and then bias current is re-applied for a subsequent logic interval.

In an actual clock power system, the zero state is held for a slight interval of time in order to avoid a so-called punch-through phenomenon, and the ratio between the duration of a logic interval and the period of the clock power is understood to be a duty ratio ($\alpha$). The duty ratio ($\alpha$) is preferably as great as possible.

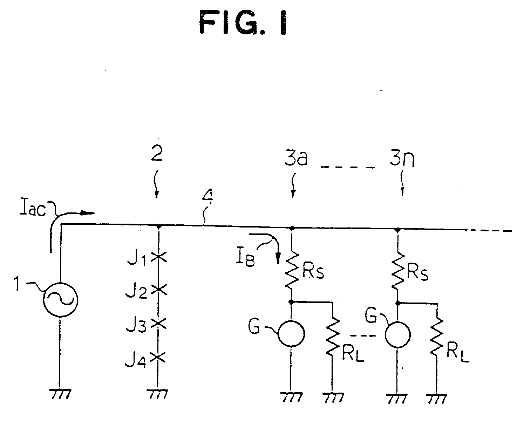

Fig. 1 illustrates a conventional power unit used in a superconducting circuit. In Fig. 1, 1 is an AC power source, 2 is a regulator part, and 3a to 3n are superconducting logic circuits. The regulator part 2 is constructed such that four Josephson junctions $J_1$ to $J_4$ are connected in series between a power bus 4 and ground. $R_S$ is a supply resistance, $R_L$ is a load resistance and G a Josephson gate.

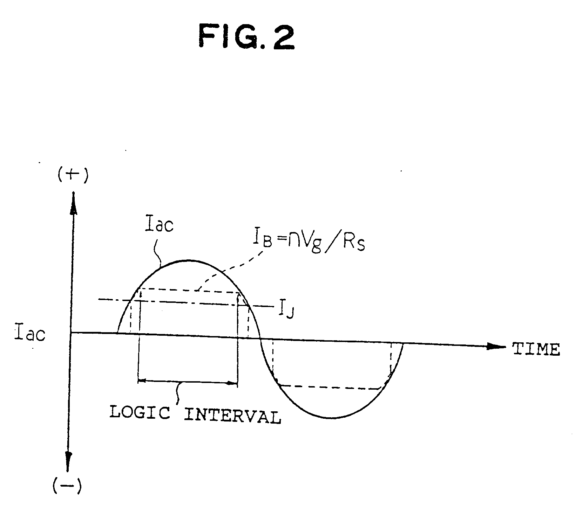

If, in such a construction, a sinusoidal current $I_{ac}$ (Fig. 2) from the AC power source 1 exceeds a maximum Josephson current $I_J$ of the regulator 2, a bias current $I_B$ starts flowing in the superconducting logic circuits 3a to 3n. When the sinusoidal current $I_{ac}$ from the AC power source 1 is further increased and the voltage between the power bus 4 and ground becomes nVg (where n denotes the number of Josephson junctions and Vg the gap voltage of each Josephson junction), the regulator part 2 shifts to a constant-voltage operating region, and holds the voltage of the power bus 4 to nVg (in this illustrated case, 4Vg). When this occurs, the bias current $I_B$ that flows into the superconducting logic circuits 3a to 3n is maintained constant (with $I_B = nVg/R_S$), and this constant interval (the period for which the bias current is maintained constant) becomes the logic interval of the superconducting logic circuits 3a to 3n.

The conventional regulator 2 of the above type has, however, a disadvantage in that the duty ratio ($\alpha$) cannot be increased, for reasons described below, as a result of the fact that four Josephson junctions are interconnected in series between the power bus 4 and ground and the logic interval is constituted by an interval of time over which all the four Josephson junctions have switched to the voltage state.

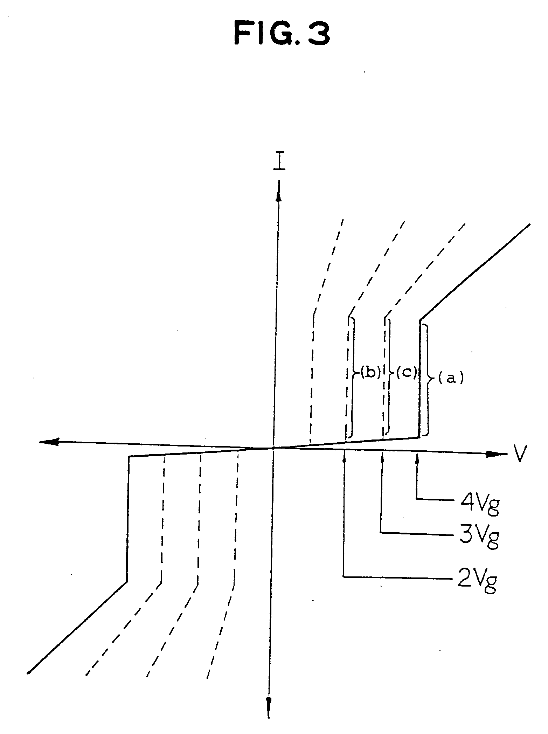

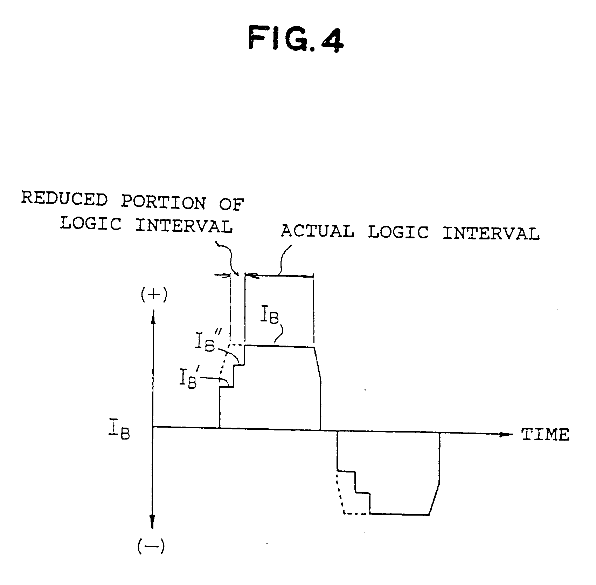

That is to say, in order to switch simultaneously all of the four Josephson junctions interconnected in series, it is necessary that these four Josephson junctions be consistent, in characteristics including critical current, with one another. However, in fact, the critical current of each Josephson junction will have a slightly different value and thus there will be a slight difference in critical current between the Josephson junctions. Consequently, that Josephson junction having the smaller critical current value is caused to switch first. In Fig. 3 which depicts an I-V characteristic of the regulator part 2, on the assumption that the four Josephson junctions $J_1$ to $J_4$ switch at the same time, the regulator 2 operates in the constant-voltage region shown by the interval (a) indicated by a solid line in Fig. 3 and holds the voltage of the power bus 4 to 4Vg during operation in this region. However, if one or more of the Josephson junctions switch first (earlier than others), for example the Josephson junctions $J_1$ and $J_2$ switch first, the constant-voltage region becomes the interval (b) indicated by a broken line in Fig. 3, and therefore the voltage of the power bus 4 at this time becomes the sum of the Vg of the Josephson junction $J_1$ and the Vg of the Junction $J_2$, i.e. 2Vg. Thereafter, if, in addition to the Josephson junctions $J_1$ and $J_2$, the Josephson junction $J_3$ switches as the sinusoidal current $I_{ac}$ from the AC power source 1 is increased, the constant-voltage region shifts from the interval (b) to the interval (c) indicated by a broken line in Fig. 3, and the voltage of the power bus 4 becomes 3Vg. Finally, the Josephson junction $J_4$ switches, and the voltage 4Vg appears in the power bus 4. As a result of this unsatisfactory switching operation, the bias current $I_B$ has waveforms as shown in Fig. 4.

That is, as indicated in Fig. 4, a bias current $I_B'$ becomes $2Vg/R_S$ when the Josephson junctions $J_1$ and $J_2$ switch, then a bias current $I_B''$ becomes $3Vg/R_S$ when the Josephson junctions $J_1$, $J_2$ and $J_3$ switch, and finally the bias current $I_B = 4Vg/R_S$ is obtained when all the Josephson junctions $J_1$, $J_2$, $J_3$ and $J_4$ switch. As a result, the interval length over which $I_B = 4Vg/R_S$, employed as a logic interval, is reduced in practice, and a sufficiently great duty ratio ($\alpha$) is not obtained.

JP-A-59-19437 by Hitachi Seisakusho K. K. discloses a superconduction digital circuit having a power source regulator according to the preamble of accompanying claim 1. This power source regulator is equivalent to two regulators of the Fig. 1 type described above, mutually connected by long and asymmetrical conducting lines.

JP-A-58-129826 by Nippon Denshin Denwa Kosha discloses a Josephson timing signal generating circuit including a power source regulator consisting of two asymmetrical branches connected in parallel. One branch has four series-connected Josephson junctions and the other has a single Josephson junction, so the two branches have different threshold current values and produce timing signals of different relative timings.

According to the present invention, there is provided a regulator of a power source for a superconducting circuit, comprising:-

a first Josephson circuit having a plurality of Josephson junctions, interconnected in series, and a resistance, one end of said series-connected Josephson junctions and one end of said resistance being connected in series with each other;

a second Josephson circuit having a plurality of Josephson junctions, interconnected in series, and a resistance, one end of said series-connected Josephson junctions and one end of said resistance being connected in series with each other;

said first Josephson circuits being connected in parallel with each other;

one end of each of said Josephson circuit, adjacent the other end of said resistance of the Josephson circuit concerned, being connected to a first power source line so that a sinusoidal current is supplied to said Josephson circuits; and

the other end of each Josephson circuit, adjacent the other end of said series-connected Josephson junctions of the Josephson circuit concerned, being connected to a second power source line; and further comprising:-

means for outputting clock currents from a first terminal, between said one end of said series-connected Josephson junctions and said one end of said resistance of said first Josephson circuit, or from a second terminal, between said one end of said series-connected Josephson junctions and said one end of said resistance of said second Josephson circuit, in response to said sinusoidal current from said first power source line; characterised in that:-

said first and second Josephson circuits are parallel branch paths of the same integrated circuit, and are symmetrical and have symmetrical connections to the first power source line; and in that said Josephson junctions and said resistance of said first Josephson circuit are nominally identical to those of said second Josephson circuit, whereby in use, switching of all said series-connected Josephson junctions of said parallel Josephson circuits occurs practically simultaneously in response to the sinusoidal current from the first power source.

An embodiment of the present invention can provide an improved regulator of a power source for a superconducting circuit, having an improved duty ratio ($\propto$), and can provide such a regulator wherein a logic interval is increased and a duty ratio ($\propto$) of the regulator is increased, by causing switching of a plurality of Josephson junctions interconnected in series to take place quickly and simultaneously or practically so.

If, in an embodiment of the present invention, at least one Josephson junction in one branch path (Josephson circuit) switches, the current (half of the sinusoidal current) flowing in this branch flows in the other or another branch path and thus all the Josephson junctions in this other branch path are caused to switch very rapidly. This switching operation of this other branch path causes the current (all of the sinusoidal current) to flow again in the one branch path, so that the remaining Josephson junctions in this one branch are all switched.

That is, a series of switching operations, which consist of (1) the switching operation of one Josephson junction of one branch path, (2) the switching operations of all the Josephson junctions of the other branch path(s) and (3) the switching operations of the remaining Josephson junctions in the one branch path, are instantaneously, or practically so, carried out.

As a result, the times ((1) - (2), (1) - (3)) until the voltage between the two ends of the first branch path and between the two ends of the second (or other) branch path(s) operate with a value obtained by multiplying the number of Josephson junctions by Vg, is reduced. A constant operating interval (logic interval) is consequently increased so that a duty ratio ($\alpha$) can be increased.

Reference is made, by way of example, to the accompanying drawings, in which:-

Fig. 1 is a diagram illustrating schematically a conventional regulator of a power source for a superconducting circuit,

Fig. 2 is a waveform diagram, illustrating the waveform of a sinusoidal current employed in the conventional regulator of Fig. 1,

Fig. 3 is a diagram representing graphically variation of I-V characteristic of the regulator of the conventional regulator of Fig. 1,

Fig. 4 is a detail waveform diagram, showing the waveform of a bias current obtained with the conventional regulator of Fig. 1,

Fig. 5 is a diagram illustrating schematically a regulator of a power source for a superconducting circuit, according to an embodiment of the present invention,

Fig. 6 is a diagram illustrating schematically the circuit of a Josephson gate G of Fig. 5,

Fig. 7 is a schematic sectional diagram serving to illustrate an example of a production process for providing a regulator in accordance with an embodiment of the present invention and a Josephson gate G as in Fig. 5, and

Fig. 8 is a schematic diagram illustrating a four-input OR circuit wherein a plurality of Josephson MVTL OR gates are used in place of a Josephson gate G of Fig. 5.

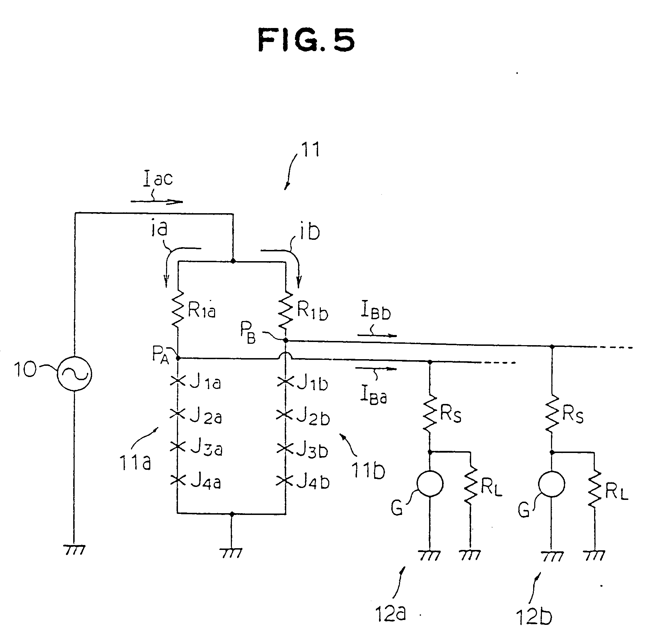

Referring initially to Fig. 5, there is shown an embodiment of a regulator of a power source for a superconducting circuit, which is constructed in accordance with an embodiment of the present invention.

In Fig. 5, 10 is an AC power source for generating a sinusoidal current $I_{ac}$, 11 generally designates a regulator part for outputting clock currents $I_{Ba}$ and $I_{Bb}$ through two terminals $P_A$ and $P_B$ in response to the sinusoidal current $I_{ac}$ from the AC power source 10, and 12a and 12b generally designate superconducting logic gates that operate in response to the respective clock currents $I_{Ba}$ and $I_{Bb}$ from the regulator part 11. A supply resistance of each logic gate is denoted by $R_S$, a load resistance of each logic gate by $R_L$, and a Josephson gate of each logic gate by G.

The regulator part 11 comprises a first branch path 11a having a plurality of Josephson junctions (in this embodiment, $J_{1a}$ to $J_{4a}$) - interconnected in series - and a resistance $R_{1a}$ which are connected in series with each other, and a second branch path 11b having the same construction as the first branch path 11a and thus having a plurality of Josephson junctions (in this embodiment, $J_{1b}$ to $J_{4b}$) - interconnected in series - and a resistance $R_{1b}$ which are connected in series with each other. These first and second branch paths 11a and 11b are connected in parallel with each other, the sinusoidal current $I_{ac}$ from the AC power source 10 being supplied to the end of the parallel-connected first and second branch paths 11a and 11b remote from ground. It is noted that the aforementioned resistances $R_{1a}$ and $R_{1b}$ are provided to prevent a looped current from occurring in the first and second superconducting branch paths 11a and 11b and thus can assume very small values, respectively.

In the construction as described above, if now the sinusoidal current $I_{ac}$ from the AC power source 10 is substantially equal to zero, all the Josephson junctions $J_{1a}$ to $J_{4a}$ and $J_{1b}$ to $J_{4b}$ in the regulator part 11 are in the superconducting state. As the current $I_{ac}$ from the AC power source 10 is increased from zero, this current $I_{ac}$ is divided into two currents ia and ib (where ia = ib = $I_{ac}/2$) which flow through the first and second branch paths 11a and 11b, respectively. These currents ia and ib return to the AC power source 10 through each of the Josephson junctions, in the superconducting state, and ground.

If the currents ia and ib increase as the current $I_{ac}$ is increased, and exceed the critical current $I_c$ of a Josephson junction, one or some of the Josephson junctions immediately switch to the voltage state. Now, assuming that the Josephson junction $J_{1b}$ of the second branch path 11b switches to the voltage state, the current ib (= ia = $I_{ac}/2$) flowing in the second branch path 11b is caused to flow into the first branch path 11a due to switching of the Josephson junction $J_{1b}$, and therefore the current that flows through the first branch path 11a becomes ia + ib, i.e. $I_{ac}$. Consequently, all the Josephson junctions $J_{1a}$ to $J_{4a}$ in the first branch path 11a immediately switch to the voltage state. This causes the current $I_{ac}$ to flow into the second branch path 11b, and the Josephson junctions $J_{2b}$ to $J_{4b}$ of the second branch path 11b that are still in the superconducting state immediately switch to the voltage state. The switching operations of all of the Josephson junctions $J_{1a}$ to $J_{4a}$ of the first branch path 11a and the Josephson junctions $J_{1b}$ to $J_{4b}$ of the second branch path 11b cause a voltage nVg (where n denotes the number of Josephson junctions in each branch path and Vg the gap voltage of each Josephson junction) to be generated between the terminal $P_A$ of the first branch path 11a and ground and also between the terminal $P_B$ of the second branch path 11b and ground. This voltage nVg is maintained constant. The bias current $I_{Ba}$ from the terminal $P_A$ of the first branch path 11a is supplied to the superconducting logic gate 12a, while the bias current $I_{Bb}$ from the terminal $P_B$ of the second branch path 11b is supplied to the superconducting logic gate 12b. These bias currents $I_{Ba}$ and $I_{Bb}$ are given by the following equation:-

$$I_{Ba} = I_{Bb} = nVg/R_S$$

and assume constant values, respectively.

Thus, the regulator 11 of the embodiment described above comprises two branch paths, i.e. first and second branch paths 11a and 11b, and if at least one Josephson junction of one of these branch paths switches, the current flowing in the one branch path, which includes the Josephson junction that has switched, flows into the other branch path. Consequently, all the Josephson junctions in the other branch path immediately switch, and by this switching, the current path changes from the other branch path to the one branch path and therefore all the Josephson junctions in the one branch path immediately switch. Thus, by the switching operation of one Josephson junction, the switching operations of all of the Josephson junctions of the other branch path and the switching operations of all of the Josephson junctions of the one branch path are consecutively effected, so that the transition to the constant-voltage operating region can be instantaneously, or very nearly instantaneously, carried out. Consequently, the interval of the constant-Voltage operating region, i.e. the logic interval can be increased and the duty ratio ($\alpha$) thus increased. It is noted that, if more Josephson junctions interconnected in series are provided, fluctuation in the bias current value could be more effectively prevented. On the other hand, it is necessary to reduce the number of Josephson junctions to save power consumption. It is consequently preferable that the series connections of Josephson junctions comprise four Josephson junctions.

While it has been illustrated and described in the embodiment described above that the number of Josephson junctions is four in each of the first and second branch paths 11a and 11b, it is noted that the present invention is not limited to such use of four Josephson junctions.

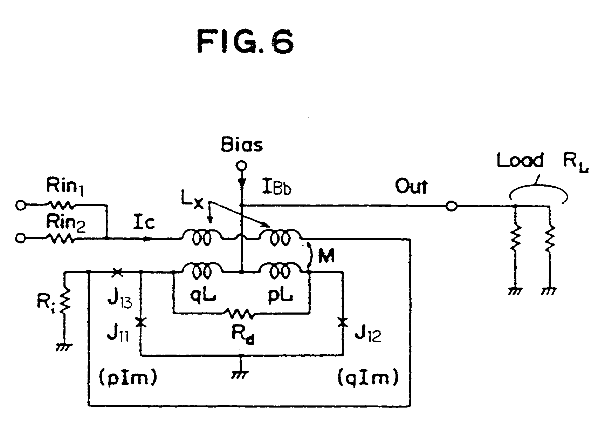

Fig. 6 is a circuit diagram illustrating a Josephson gate G wherein the bias current $I_{Bb}$ is supplied from the regulator part 11, as shown in Fig. 5, and which gate is described in IEEE TRANSACTIONS ON ELECTRON DEVICES, Vol. 36, No. 2, pages 433 to 446, February 1989. The gate shown in Fig. 6 is a Josephson MVTL (modified variable threshold logic) OR gate of the injection type wherein the sensibility of (sensitivity to) an input signal is enhanced by both the effect of magnetic coupling and the effect of current injection. The Josephson MVTL OR gate is an asymmetric interferometer and consists of two Josephson junctions $J_{11}$ and $J_{12}$ and inductances qL and pL. The critical current of $J_{11}$ is plm and that of $J_{12}$ is qlm, where p + q = 1. The inductances qL and pL are magnetically coupled to an inductance Lx through a mutual inductance M. The bias current $I_{Bb}$ from the regulator part 11 is injected into the point between the left branch inductance qL and the right branch inductance pL. This ensures that the upper limit of the bias current is at its maximum Im. An input signal or current Ic is added and fed through resistances Rin1 and Rin2 and the inductance Lx and injected into the interferometer through an isolator junction $J_{13}$. The switching operation is as follows. When the input signal Ic is not supplied to the resistances Rin1 and Rin2, each of the junctions $J_{11}$, $J_{12}$ and $J_{13}$ is in the superconducting state. When the input signal Ic is supplied to at least one of the resistances Rin1 and Rin2, the input signal Ic flows through the inductance Lx, junction $J_{13}$ and junction $J_{11}$ to the ground. At the same time, by the magnetic coupling of the inductance Lx to the inductance pL, a screening current Is flows through the inductance pL, inductance qL, junction $J_{11}$, and junction $J_{12}$ and returns back to the inductance pL. In this case, since the bias, screening and input currents flow through the junction $J_{11}$ in the same direction and the added current ($I_{Bb}$ + Is + Ic) exceeds the critical current of the junction $J_{11}$, the junction $J_{11}$ switches from the superconducting state to the voltage state. For this reason, the bias current flowing in the junction $J_{11}$ then flows into the junction $J_{12}$, and therefore the junction $J_{12}$ switches from the superconducting state to the voltage state. The bias current then flows through qL, $J_{13}$ and Ri to ground, and causes the junction $J_{13}$ to switch to the voltage state. Finally, almost all of the bias current flows to the load resistance $R_L$. Thus, the output attains an ON state, and OR logic is performed.

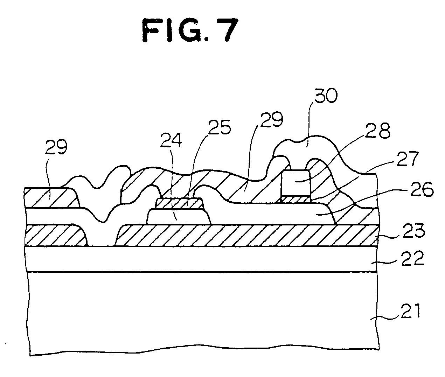

Fig. 7 serves to illustrate an example of a production process of a regulator according to an embodiment of the present invention and a Josephson gate G. The production process is described, for example in Appl. Phys. Lett., Vol. 48, No. 20, pages 254 to 256, January 1986, and J. Appl. Phys., Vol 62, pages 3432 to 3435, October 1987. In Fig. 7, 21 denotes a substrate, 22 a ground plane, 23 an insulation layer I1, 24 a resistor, 25 a protection layer, 26 a base of a Nb/AlOx/Nb Josephson junction, 27 a barrier of the junction, 28 a counter of the junction, 29 an insulation layer I2 and 30 a wiring layer. The material and thickness of each layer are indicated in the Table.

## TABLE

| Layer | Material | Thickness (nm) |
|---|---|---|
| Ground plane | Nb | 300 |
| Insulation (I1) | $SiO_2$ | 300 |
| Resistor | Mo | 100 |
| Protection | SiOx | 200 |
| Junction base | Nb | 200 |
| " barrier | Al-AlOx | 3 |
| " counter | Nb | 150 |
| Insulation (I2) | SiOx | 400 |
| Wiring | Nb | 600 |

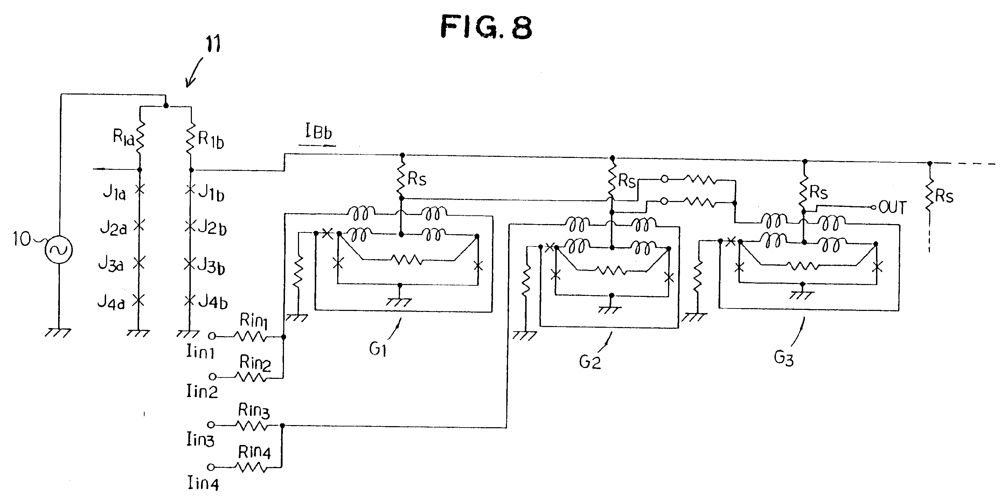

Fig. 8 illustrates a four-input OR circuit wherein a plurality of Josephson MVTL OR gates are used in place of a Josephson gate G as shown in Fig. 5. Rin1 to Rin 4 denote resistances and Iin1 to Iin4 denote input currents. While in Fig. 8 only one of the bias currents $I_{Ba}$ and $I_{Bb}$ from the regulator 11 is supplied to the Josephson gates, naturally, the other bias current $I_{Ba}$ is also supplied to Josephson gates (not shown). Although only three Josephson MVLT OR gates are shown, it is noted that, in fact, the bias current $I_{Bb}$ supplied from one regulator is or may be used for Josephson gates of the order of 100 in number.

From the foregoing description, it will be seen that a plurality of Josephson junctions interconnected in series are switched very quickly and simultaneously, or practically so, in accordance with an embodiment of the present invention, thereby increasing the logic interval and the duty ratio ($\alpha$).

An embodiment of the present invention provides a regulator of a power source for a superconducting circuit, comprising: a first branch path (11a) having a plurality of Josephson junctions ($J_{1a}$ to $J_{4a}$), interconnected in series, and a resistance ($R_{1a}$); a second branch path (11b) having a plurality of Josephson junctions ($J_{1b}$ to $J_{4b}$), interconnected in series, and a resistance ($R_{1b}$); said first and second branch paths (11a, 11b) being connected in parallel with each other; one end of said parallel branch paths (11a, 11b) being connected to a first power source (10) so that a sinusoidal current is supplied to said parallel branch paths (11a, 11b); the other end of said parallel branch paths (11a, 11b) being connected to a second power source; and means for outputting clock currents from a first terminal ($P_A$) between said series-connected Josephson junctions and said resistance of said first branch path (11a) or from a second terminal ($P_B$) between said series-connected Josephson junctions and said resistance of said second branch path (11b), in response to said sinusoidal current from said first power source (10).

## Claims

1. A regulator of a power source for a superconducting circuit, comprising:-

   a first Josephson circuit (11a) having a plurality of Josephson junctions ($J_{1a}$ to $J_{4a}$), interconnected in series, and a resistance ($R_{1a}$), one end of said series-connected Josephson junctions ($J_{1a}$ to $J_{4a}$) and one end of said resistance ($R_{1a}$) being connected in series with each other;

   a second Josephson circuit (11b) having a plurality of Josephson junctions ($J_{1b}$ to $J_{4b}$), interconnected in series, and a resistance ($R_{1b}$), one end of said series-connected Josephson junctions ($J_{1b}$ to $J_{4b}$) and one end of said resistance ($R_{1b}$) being connected in series with each other;

   said first and second Josephson circuits (11a, 11b) being connected in parallel with each other;

   one end of each of said Josephson circuit (11a, 11b), adjacent the other end of said resistance ($R_{1a}$, $R_{1b}$) of the Josephson circuit (11a, 11b) concerned, being connected to a first power source (10) line so that a sinusoidal current is supplied to said Josephson circuits (11a, 11b); and

   the other end of each Josephson circuit (11a, 11b), adjacent the other end of said series-connected Josephson junctions of the Josephson circuit concerned, being connected to a second power source line; and further comprising:-

   means for outputting clock currents from a first terminal ($P_A$), between said one end of said series-connected Josephson junctions and said one end of said resistance of said first Josephson circuit (11a), or from a second terminal ($P_B$), between said one end of said series-connected Josephson junctions and said one end of said resistance of said second Josephson circuit (11b), in response to said sinusoidal current from said first power source (10) line; characterised in that:-

   said first and second Josephson circuits (11a, 11b) are parallel branch paths of the same integrated circuit, and are symmetrical and in that said Josephson junctions and said resistance of said first Josephson circuit (11a) are nominally identical to those of said second Josephson circuit (11b), whereby in use, switching of all said series-connected Josephson junctions of said parallel Josephson circuits (11a, 11b) occurs practically simultaneously in response to the sinusoidal current from the first power source.

2. A regulator as claimed in claim 1, wherein said means for outputting clock currents is connected to a bias-current supplying terminal of at least one or more Josephson logic gates (12a, 12b).

3. A regulator as claimed in claim 1 or 2, wherein said second power source line is a ground line.

4. A regulator as claimed in claim 1, 2 or 3, wherein said series-connected Josephson junctions of said first Josephson circuit (11a) comprise four Josephson junctions ($J_{1a}$ to $J_{4a}$), and said series-connected Josephson junctions of said second Josephson circuit (11b) comprise four Josephson junctions ($J_{1b}$ to $J_{4b}$).

**Patentansprüche**

1.  Ein Regler einer Energiequelle für eine supraleitende Schaltung, mit:-

    einer ersten Josephson-Schaltung (11a) mit einer Vielzahl von Josephson-Übergängen ($J_{1a}$ bis $J_{4a}$), die seriell untereinander verbunden sind, und einem Widerstand ($R_{1a}$), bei der ein Ende der genannten seriell verbundenen Josephson-Übergänge ($J_{1a}$ bis $J_{4a}$) und ein Ende des genannten Widerstandes ($R_{1a}$) seriell miteinander verbunden sind;

    einer zweiten Josephson-Schaltung (11b) mit einer Vielzahl von Josephson-Übergängen ($J_{1b}$ bis $J_{4b}$), die seriell untereinander verbunden sind, und einem Widerstand ($R_{1b}$), bei der ein Ende der genannten seriell verbundenen Josephson-Übergänge ($J_{1b}$ bis $J_{4b}$) und ein Ende des genannten Widerstandes ($R_{1b}$) seriell miteinander verbunden sind;

    welche ersten und zweiten Josephson-Schaltungen (11a, 11b) parallel miteinander verbunden sind;

    bei dem ein Ende von jeder der genannten Josephson-Schaltungen (11a, 11b), das an das andere Ende des genannten Widerstandes (R1a, R1b) der betreffenden Josephson-Schaltung (11a, 11b) angrenzt, mit einer ersten Energiequellen-(10)-Leitung verbunden ist, so daß den genannten Josephson-Schaltungen (11a, 11b) ein Sinusstrom zugeführt wird; und

    das andere Ende von jeder Josephson-Schaltung (11a, 11b), das an das andere Ende der genannten seriell verbundenen Josephson-Übergänge der betreffenden Josephson-Schaltung angrenzt, mit einer zweiten Energiequellenleitung verbunden ist; und ferner mit:-

    einem Mittel zum Ausgeben von Taktströmen von einem ersten Anschluß ($P_A$), zwischen dem genannten einen Ende der genannten seriell verbundenen Josephson-Übergänge und dem genannten einen Ende des genannten Widerstandes der genannten ersten Josephson-Schaltung (11a), oder von einem zweiten Anschluß ($P_B$), zwischen dem genannten einen Ende der genannten seriell verbundenen Josephson-Übergänge und dem genannten einen Ende des genannten Widerstandes der genannten zweiten Josephson-Schaltung (11b), als Reaktion auf den genannten Sinusstrom von der genannten ersten Energiequellen-(10)-Leitung; dadurch gekennzeichnet, daß:-

    die genannten ersten und zweiten Josephson-Schaltungen (11a, 11b) parallele Zweigwege derselben integrierten Schaltung sind und symmetrisch sind; und daß die genannten Josephson-Übergänge und der genannte Widerstand der genannten ersten Josephson-Schaltung (11a) nominell identisch mit jenen der genannten zweiten Josephson-Schaltung (11b) sind, wodurch bei Gebrauch das Schalten aller genannten seriell verbundenen Josephson-Übergänge der genannten parallelen Josephson-Schaltungen (11a, 11b) als Reaktion auf den Sinusstrom von der ersten Energiequelle praktisch gleichzeitig erfolgt.

2.  Ein Regler nach Anspruch 1, bei dem das genannte Mittel zum Ausgeben von Taktströmen mit einem Vorspannungsstromzuführungsanschluß von wenigstens einem oder mehreren Josephson-Logikgattern (12a, 12b) verbunden ist.

3.  Ein Regler nach Anspruch 1 oder 2, bei dem die genannte zweite Energiequellenleitung eine Erdleitung ist.

4.  Ein Regler nach Anspruch 1, 2 oder 3, bei dem die genannten seriell verbundenen Josephson-Übergänge der genannten ersten Josephson-Schaltung (11a) vier Josephson-Übergänge ($J_{1a}$ bis $J_{4a}$) umfassen, und die genannten seriell verbundenen Josephson-Übergänge der genannten zweiten Josephson-Schaltung (11b) vier Josephson- ($J_{1b}$ bis $J_{4b}$) umfassen.


**Revendications**

1.  Régulateur de source d'alimentation électrique pour circuit supraconducteur, comprenant:

    un premier circuit Josephson (11a) comportant plusieurs jonctions Josephson ($J_{1a}$ à $J_{4a}$), interconnectées en série, et une résistance ($R_{1a}$), une extrémité desdites jonctions Josephson connectées en série($J_{1a}$ à $J_{4a}$) et une extrémité de ladite résistance ($R_{1a}$) étant connectées en série l'une avec l'autre ;

    un deuxième circuit Josephson (11b) comportant plusieurs jonctions Josephson ($J_{1b}$ à $J_{4b}$), interconnectées en série, et une résistance ($R_{1b}$), une extrémité desdites jonctions Josephson connectées en série ($J_{1b}$ à $J_{4b}$) et une extrémité de ladite résistance ($R_{1b}$) étant connectées en série l'une avec l'autre ;

    lesdits premier et deuxième circuits Josephson (11a, 11b) étant connectés mutuellement en parallèle ;

une extrémité de chacun desdits circuits Josephson (11a, 11b), adjacente à l'autre extrémité de ladite résistance ($R_{1a}$, $R_{1b}$) du circuit Josephson (11a, 11b) concerné, étant connectée à une première ligne de source d'alimentation électrique (10) si bien qu'un courant sinusoïdal est fourni auxdits circuits Josephson (11a, 11b) ; et

l'autre extrémité de chaque circuit Josephson (11a, 11b), adjacente à l'autre extrémité desdites jonctions Josephson connectées en série du circuit Josephson concerné, étant connectée à une deuxième ligne de source d'alimentation électrique ; et comprenant en outre :

un moyen servant à délivrer des courants d'horloge en provenance d'une première borne ($P_A$), se trouvant entre ladite extrémité citée en premier desdites jonctions Josephson connectées en série et ladite extrémité citée en premier de ladite résistance dudit premier circuit Josephson (11a), ou bien en provenance d'une deuxième borne ($P_B$), se trouvant entre ladite extrémité citée en premier desdites jonctions Josephson connectées en série et ladite extrémité citée en premier de ladite résistance dudit deuxième circuit Josephson (11b), en réponse audit courant sinusoïdal venant de ladite première ligne de source d'alimentation électrique (10); caractérisé en ce que :

les premier et deuxième circuits Josephson (11a, 11b) sont des trajets de ramification parallèles du même circuit intégré et sont symétriques ; et en ce que lesdites jonctions Josephson et ladite résistance dudit premier circuit Josephson (11a) sont nominalement identiques à celles dudit deuxième circuit Josephson (11b), de sorte que, en utilisation, la commutation de toutes lesdites jonctions Josephson connectées en série desdits circuits Josephson parallèles (11a, 11b) se produit pratiquement simultanément en réponse au courant sinusoïdal venant de la première source d'alimentation électrique.

2. Régulateur selon la revendication 1, où ledit moyen servant à délivrer des courants d'horloge est connecté à une borne d'alimentation en courant de polarisation d'au moins une ou de plusieurs portes logiques à effet Josephson (12a, 12b).

3. Régulateur selon la revendication 1 ou 2, où ladite deuxième ligne d'alimentation électrique est une ligne de connexion à la terre.

4. Régulateur selon la revendication 1, 2 ou 3, où lesdites jonctions Josephson connectées en série dudit premier circuit Josephson (11a) comprennent quatre jonctions Josephson ($J_{1a}$ à $J_{4a}$), et lesdites jonctions Josephson connectées en série dudit deuxième circuit Josephson (11b) comprennent quatre jonctions Josephson ($J_{1b}$ à $J_{4b}$).

# FIG. I

# FIG. 2

# FIG. 3

EP 0 354 547 B1

# FIG.4

REDUCED PORTION OF
LOGIC INTERVAL

ACTUAL LOGIC INTERVAL

12

# FIG. 5

# FIG. 6

# FIG. 7

# FIG. 8

EP 0 354 547 B1